(19) **Europäisches Patentamt**
**European Patent Office**
**Office européen des brevets**

(11) Veröffentlichungsnummer: **0 354 181 B1**

(12) **EUROPÄISCHE PATENTSCHRIFT**

(45) Veröffentlichungstag der Patentschrift: **25.01.95**

(51) Int. Cl.6: **C08G 59/68**, B01J 31/12, B01J 31/22, B01J 31/06

(21) Anmeldenummer: **89810571.3**

(22) Anmeldetag: **26.07.89**

(54) **Härterkombination für kationisch polymerisierbare Materialien.**

(30) Priorität: **04.08.88 CH 2959/88**

(43) Veröffentlichungstag der Anmeldung:
**07.02.90 Patentblatt 90/06**

(45) Bekanntmachung des Hinweises auf die Patenterteilung:
**25.01.95 Patentblatt 95/04**

(84) Benannte Vertragsstaaten:
**AT BE CH DE FR GB IT LI NL SE**

(56) Entgegenhaltungen:
AT-B- 384 025
US-A- 4 740 577

(73) Patentinhaber: **CIBA-GEIGY AG**
**Klybeckstrasse 141**
**CH-4002 Basel (CH)**

(72) Erfinder: **Baumann, Dieter**
**Bürklistrasse 6**
**CH-4313 Möhlin (CH)**
Erfinder: **Meier, Kurt**
**Im Kirschgarten 35**
**CH-4102 Binningen (CH)**
Erfinder: **Margotte, Werner**
**Leimenweg 6**
**CH-4419 Lupsingen (CH)**
Erfinder: **Müller, Beat**
**Chemin des Cossettes 5**
**CH-1723 Marly (CH)**

## Beschreibung

Die vorliegende Erfindung betrifft neue Stoffzusammensetzungen, die sich als Härter für kationisch polymeriserbare Materialien einsetzen lassen, kationisch polymerisierbare Materialien enthaltend diese Härter, ein Verfahren zum Härten besagter Materialien und die Verwendung der neuen Stoffgemische als Härter für kationisch polymerisierbare Materialien.

Die Verwendung von Metallocenkomplexen als Härter für kationisch und/oder radikalisch polymerisierbare Materialien ist an sich bekannt.

In den EP-A-94,915 und -109,851 werden härtbare Gemische beschrieben, die kationisch polymerisierbare Materialien, bevorzugt Epoxidharze, und als Härter Metallocensalze enthalten. Ferner sind aus der EP-A-94,915 aktivierte Zusammensetzungen bekannt, die durch Bestrahlen der härtbaren Zusammensetzungen mit aktinischer Strahlung erhalten werden und die bei im Vergleich zur direkten Härtung niedrigeren Temperaturen ausgehärtet werden können.

Aus der EP-A-126,712 sind Kombinationen von kationisch und/oder radikalisch polymerisierbaren Materialien bekannt, die ein Eisen-Aren Komplexsalz und ein Oxidationsmittel enthalten.

Die EP-A-152,377 beschreibt Kombinationen von kationisch und/oder radikalisch polymerisierbarem Material, ausgewählten Eisen-Aren Komplexsalzen, Sensibilisatoren und gegebenenfalls Oxidationsmitteln.

Ferner sind aus der US-A-4,740,577 polymerisierbare Zusammensetzungen bekannt, die einen Polyurethan-Vorläufer und als Härtungsmittel ein Salz eines organischen Komplexkations enthalten.

Alle diese vorbekannten Zusammensetzungen weisen als gemeinsames Merkmal auf, dass man die metallorganischen Komplexsalze nach dem Einmischen in das zu polymerisierende Material vor einer thermischen Härtung durch Bestrahlen mit aktinischer Strahlung aktiviert, wobei je nach Material und Bestrahlungsbedingungen eine teilweise Polymerisation ablaufen kann, und anschliessend thermisch härtet, oder dass die direkte thermische Härtung bei hohen Temperaturen, beispielsweise nahe des Zersetzungspunktes des Komplexsalzes, abläuft.

Für eine Reihe von Anwendungen, wie beispielsweise beim Einsatz in Encapsulier- oder Umhüllungsprozessen bei der Herstellung von integrierten Schaltungen oder als rasch härtende Einkomponentenkleber sind härtbare Zusammensetzungen erwünscht, die eine Kombination von an sich gegenläufigen und daher schwierig zu realisierenden Eigenschaften, wie ausreichender Lagerstabilität der ungehärteten Zusammensetzung und einer möglichst raschen Härtungsgeschwindigkeit bei möglichst niedrigen Temperaturen, miteinander vereinen.

Es besteht noch ein genereller Bedarf nach härtbaren Zusammensetzungen, die dieses äusserst wünschenswerte Anforderungsprofil erfüllen.

Es wurden jetzt Härterkombinationen für kationisch polymerisierbare organische Materialien gefunden, mit denen eine rasche Gelierung bei im Vergleich zu vorbekannten Zusammensetzungen tiefen Temperaturen möglich ist und bei denen nur kurze Nachhärtzeiten bzw. niedrige Nachhärttemperaturen erforderlich sind. Gleichzeitig besitzen diese härtbaren Zusammensetzungen eine gute Lagerstabilität, so dass sich beim Einsatz in den oben genannten Prozessen Vorteile in der Verarbeitung ergeben.

Ferner kann bei den neuen Härterkombinationen eine Aktivierung der härtbaren Zusammensetzungen durch Bestrahlen vor dem Härtungsschritt entfallen, so dass sich generell eine Vereinfachung bei der Verarbeitung ergibt, insbesondere bei Systemen mit hohem Füllstoffanteil oder bei der Härtung in dicken Schichten, bei denen eine vollständige Bestrahlung der gesamten härtbaren Zusammensetzung problematisch sein kann.

Die vorliegende Erfindung betrifft eine Härterzusammensetzung für kationisch polymerisierbares Material, die erhältlich ist durch
A) Lösen oder Dispergieren einer Komponente i) in einer Komponente ii), wobei Komponente i) eine Verbindung der Formel I ist

$$[(R^1)(R^2 Fe^{II})_a]^{+na} \, na \, X^- \qquad (I)$$

und Komponente ii) ausgewählt wird aus der Gruppe bestehend aus einer Polycarbonsäure, einem Anhydrid auf Basis einer Polycarbonsäure oder einem Polyisocyanat, worin $R^1$ in Formel I ein $\pi$-Aren ist, $R^3$ ein $\pi$-Aren oder ein Anion eines $\pi$-Arens ist, a und n unabhängig voneinander 1 oder 2 bedeuten, und X ein Anion $[LQ_m]^-$ ist oder ein Anion einer gegebenenfalls teil- oder perfluorierten aliphatischen, cycloaliphatischen, aromatischen oder araliphatischen Carbonsäure oder Sulfonsäure ist, wobei L ausgewählt ist aus der Gruppe bestehend aus B, P, As, Sb und Bi, Q ein Halogenatom darstellt und m der um Eins vergrösserten Wertigkeit von L entspricht, und B) Aktivieren besagter Lösung oder Dispersion enthaltend Komponenten i) und ii) durch Bestrahlung mit aktinischer Strahlung oder durch Erhitzen, so dass eine so vollständige Umsetzung der Komponente i) des Ausgangsgemisches erfolgt, dass sich diese nicht mehr durch Dünnschicht- oder Säulenchromatographie aus der aktivierten Härterzusammensetzung abtrennen lässt.

Unter einem $\pi$-Aren $R^1$ oder $R^2$ versteht man ganz allgemein einen ein- oder zweizähnigen neu-

tralen aromatischen $\pi$-Liganden, der jeweils 6 $\pi$-Elektronen zur Valenzschale des $Fe^{II}$ beiträgt und somit über sein aromatisches $\pi$-System mit der Valenzschale des $Fe^{II}$ eine Komplexbindung eingeht.

In der Regel handelt es sich bei diesen Liganden um nichtbasische heterocyclisch-aromatische oder insbesondere carbocyclisch-aromatische Kohlenwasserstoffe, die ein- oder mehrkernig und, im Fall von mehrkernigen Resten, unkondensiert oder kondensiert sein können.

Diese Liganden können unsubstituiert sein oder sie können mit ein oder mehreren nichtbasischen Resten substituiert sein.

Bevorzugte $\pi$-Arene $R^1$ oder $R^2$ sind carbocyclisch-aromatische Kohlenwasserstoffe mit 6-24 C-Atomen, insbesondere mit 6-12 C-Atomen, im aromatischen Ring, oder heterocyclisch-aromatische Kohlenwasserstoffe mit 4-11 C-Atomen und 1 oder 2 O- oder S-Atomen im aromatischen Ring, wobei diese Liganden durch gleiche oder verschiedene einwertige Reste, wie Halogenatome, vorzugsweise Chlor- oder Bromatome, Alkyl, vorzugsweise $C_1$-$C_8$-Alkyl, Alkoxy, vorzugsweise $C_1$-$C_8$-Alkoxy, Alkylthio, vorzugsweise $C_1$-$C_8$-Alkylthio, oder durch Phenylreste ein- oder mehrfach substituiert sein können.

Unkondensierte, mehrkernige $\pi$-Arene können direkt oder über Brückenglieder, wie $-CH_2-$, $-C(CH_3)_2-$, $-CH=CH-$, $-O-$, $-S-$, $-SO_2-$ oder $-CO-$, verknüpft sein.

Die Alkyl-, Alkoxy- oder Alkylthiogruppen können geradkettig oder verzweigt sein.

Als typische Alkylgruppen seien Methyl, Ethyl, n-Propyl, Isopropyl, n-Butyl, Isobutyl, n-Pentyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Pentadecyl, n-Hexadecyl, n-Heptadecyl, n-Octadecyl, n-Nonadecyl und n-Eicosyl genannt.

Als typische Alkoxygruppen seien Methoxy, Ethoxy, n-Propoxy, Isopropoxy, n-Butoxy, Isobutoxy, n-Pentoxy, n-Hexoxy, n-Heptoxy, n-Octoxy, 2-Ethylhexoxy, n-Nonoxy und n-Decoxy genannt.

Als typische Alkylthiogruppen seien Methylthio, Ethylthio, n-Propylthio, Isopropylthio, n-Butylthio, Isobutylthio, n-Pentylthio, n-Hexylthio, n-Heptylthio, n-Octylthio, 2-Ethylhexylthio, n-Nonylthio und n-Decylthio genannt.

Alkyl- oder Alkoxygruppen mit 1-4 C-Atomen sind bevorzugte Substituenten.

Beispiele für geeignete $\pi$-Arene $R^1$ und $R^2$ sind Benzol, Toluol, Xylole, Ethylbenzol, Cumol, Methoxybenzol, Ethoxybenzol, Dimethoxybenzol, p-Chlortoluol, m-Chlortoluol, Chlorbenzol, Brom-benzol, Dichlorbenzol, Trimethylbenzol, Hexamethylbenzol, Trimethoxybenzol, Naphthalin, 1,2-Dihydronaphthalin, 1,2,3,4-Tetrahydronaphthalin, Methylnaphthalin, Methoxynaphthalin, Ethoxynaphthalin, Chlornaphthalin, Bromnaphthalin, Biphenyl, Stilben, Inden, 4,4'-Dimethylbiphenyl, Fluoren, Phenanthren, Anthracen, 9,10-Dihydroanthracen, Triphenyl, Pyren, Perylen, Naphthacen, Chrysen, Coronen, Thiophen, Furan, Chromen, Xanthen, Xanthon, Thioxanthon, Benzofuran, Benzothiophen, Naphthothiophen, Thianthren, Diphenylenoxid oder Diphenylensulfid.

Unter einem Anion eines $\pi$-Arens $R^2$ versteht man im allgemeinen einen anionischen aromatischen einzähnigen $\pi$-Liganden, der jeweils 6 $\pi$-Elektronen zur Valenzschale des $Fe^{II}$ beiträgt und somit über sein aromatisches $\pi$-System mit der Valenzschale des $Fe^{II}$ eine Komplexbindung eingeht.

Diese Liganden können unsubstituiert sein oder sie können mit ein oder mehreren nichtbasischen Resten substituiert sein.

Bevorzugte Anionen eines $\pi$-Arens $R^2$ sind das Indenylanion und insbesondere das Cyclopentadienylanion, wobei diese Liganden ein oder mehrfach mit den oben erwähnten Resten substituiert sein können.

Beispiele für bevorzugte Anionen eines $\pi$-Arens sind Anionen des Methyl-, Ethyl-, n-Propyl- und n-Butylcyclopentadiens, das Anion des Dimethylcyclopentadiens und insbesondere das Anion des unsubstituierten Cyclopentadiens.

Wenn a 2 ist, stellt $R^2$ vorzugsweise jeweils das gegebenenfalls substituierte Indenylanion oder insbesondere das gegebenenfalls substituierte Cyclopentadienylanion dar und $R^1$ ist ein zweizähniger $\pi$-Ligand, der pro $Fe^{II}$ jeweils 6 $\pi$-Elektronen zur Verfügung stellt; in diesem Fall ist n 1.

Der Index a ist vorzugsweise 1.

Der Index n ist vorzugsweise 1.

X- ist vorzugsweise ein Anion $[LQ_m]^-$ oder ein Anion einer teil- oder perfluorierten aliphatischen oder aromatischen Sulfonsäure.

Q ist vorzugsweise Fluor und L ist bevorzugt P, As, Sb oder Bi.

Beispiele für besonders bevorzugte Anionen $X^-$ sind $PF_6^-$, $AsF_6^-$, $SbF_6^-$, $BiF_6^-$, sowie Anionen von perfluoraliphatischen oder perfluoraromatischen Sulfonsäuren, insbesondere $CF_3\text{-}SO_3^-$, $C_2F_5\text{-}SO_3^-$, $C_3F_7\text{-}SO_3^-$, $C_4F_9\text{-}SO_3^-$, $C_6F_{13}\text{-}SO_3^-$, $C_8F_{17}\text{-}SO_3^-$, $C_6F_5\text{-}SO_3^-$ und $CF_3\text{-}C_6F_4\text{-}SO_3^-$.

Als Polycarbonsäuren, die sich als Komponente ii) einsetzen lassen, können ganz allgemein aliphatische, cycloaliphatische, aromatische oder araliphatische Verbindungen mit wenigstens zwei Carboxylgruppen, insbesondere mit zwei Carboxylgruppen, verwendet werden.

Beispiele für Polycarbonsäuren sind gesättigte aliphatische Dicarbonsäuren, wie Oxalsäure, Malonsäure, Bernsteinsäure, $\alpha$-Methylbernsteinsäure, Glutarsäure, Adipinsäure, Pimelinsäure, Azelainsäure, Sebazinsäure oder dimerisierte Linolsäure;

oder ungesättigte aliphatische Dicarbonsäuren, wie Maleinsäure, Mesaconsäure, Citraconsäure, Glutaconsäure oder Itaconsäure; oder cycloaliphatische Dicarbonsäuren, wie Hexahydrophthal-, Hexahydroisophthal- oder Hexahydroterephthalsäure, oder Tetrahydrophthal-, Tetrahydroisophthal- oder Tetrahydroterephthalsäure, oder 4-Methyltetrahydrophthalsäure, 4-Methylhexahydrophthalsäure oder Endomethylentetrahydrophthalsäure; oder aromatische Dicarbonsäuren, wie Phthal-, Isophthal- oder Terephthalsäure.

Beispiele für Tri- und höhere Carbonsäuren sind insbesondere aromatische Tri- oder Tetracarbonsäuren, wie Trimellithsäure, Trimesinsäure, Pyrromellithsäure oder Benzophenontetracarbonsäure, sowie dimerisierte oder trimerisierte Fettsäuren, wie sie beispielsweise unter der Bezeichnung Pripol® im Handel sind.

Die Anhydride der Komponente ii) leiten sich von organischen Polycarbonsäuren, insbesondere von Dicarbonsäuren, ab. Beispiele sind die Anhydride der oben aufgezählten Polycarbonsäuren.

Handelt es sich bei Komponente ii) um ein Polyisocyanat, so lässt sich im allgemeinen jede aliphatische, cycloaliphatische, aromatische oder araliphatische Verbindung mit mindestens zwei Isocyanatgruppen oder blockierten und durch Erhitzen deblockierbaren Isocyanatgruppen verwenden, in dem Komponente i) gelöst oder dispergiert werden kann.

Als Komponenten ii) werden Polyisocyanate besonders bevorzugt, da sich mit solchen Initiatorzusammensetzungen in der Regel gehärtete Produkte mit besonders hohen Glasumwandlungstemperaturen herstellen lassen, die ausserdem bei thermischer Belastung nur einen geringen Netzwerkabbau zeigen.

Beispiele für bevorzugte Polyisocyanate sind 2,4-Diisocyanatotoluol sowie dessen technische Gemische mit 2,6-Diisocyanatotoluol, 2,6-Diisocyanatotoluol, 1,5-Diisocyanatonaphthalin, 4,4'-Diisocyanatodiphenylmethan sowie technische Gemische verschiedener Diisocyanatodiphenylmethane (beispielsweise der 4,4'- und der 2,4'-Isomeren), urethanisiertes 4,4'-Diisocyanatodiphenylmethan, carbodiimidisiertes 4,4'-Diisocyanatodiphenylmethan, das Uretdion des 2,4-Diisocyanatotoluols, Triisocyanatotriphenylmethan, das Adukt aus Diisocyanatotoluol und Trimethylolpropan, des Trimerisat aus Diisocyanatotoluol, Diisocyanato-m-xylylen, N,N'-Di-(4-methyl-3-isocyanatophenyl)-harnstoff, Mischtrimerisationsprodukte von Diisocyanatotoluol und 1,6-Diisocyanatohexamethylen, 1,6-Diisocyanatohexan, 3,5,5-Trimethyl-1-isocyanatomethylcyclohexan (Isophorondiisocyanat), N,N',N"-Tri-(6-isocyanatohexyl)-biuret, 2,2,4-Trimethyl-1,6-diisocyanatohexan, 1-Methyl-2,4-diisocyanatocyclohexan, Dimeryldiisocyanat, 4,4'-Diisocyanatodicyclohexylmethan, trimeres Isophorondiisocyanat, trimeres Hexandiisocyanat und 2,6-Diisocyanatohexansäuremethylester.

Bevorzugte Polyisocyanate besitzen drei oder insbesondere zwei Isocyanatgruppen und weisen 6 bis 20 Kohlenstoffatome auf. Ganz besonders bevorzugt werden aromatische Diisocyanate, insbesondere 4,4'-Diisocyanatodiphenylmethan sowie technische Gemische verschiedener Diisocyanatodiphenylmethane, oder cycloaliphatische Diisocyanate, insbesondere Isophorondiisocyanat.

Anhydride von Polycarbonsäuren oder Gemische von Anhydriden von Polycarbonsäuren sind als Komponente ii) ebenfalls bevorzugt.

Besonders bevorzugte Anhydride von Polycarbonsäuren sind bei Temperaturen unterhalb von 50°C, insbesondere unterhalb von 30°C flüssig. Dabei kann es sich auch um flüssige Gemische veschiedener Anhydride von Polycarbonsäuren handeln.

Die Herstellung des Ausgangsgemisches erfolgt in der Regel durch einfaches Vermischen der Komponenten i) und ii), gegebenenfalls unter Erwärmen, so dass sich eine Lösung von i) in ii) bildet. Für den Fall, dass die Ausgangskomponenten nicht oder nur teilweise ineinander löslich sind, kann man auch mit einer Dispersion von Komponente i) in ii) arbeiten. Dazu kann man die Mischung in an sich bekannter Weise aufschmelzen und mit Ultraschall behandeln.

Vorzugsweise wählt man Komponenten i) und ii) und deren Mengen so aus, so dass sich eine Lösung aus diesen Komponenten herstellen lässt.

Die Struktur der erfindungsgemässen aktiverten Härterkomponente kann nicht mit Sicherheit angegeben werden. Durch Aktivieren mittels Erhitzen oder Bestrahlen mit aktinischer Strahlung wird Komponente i) in der Ausgangsmischung umgesetzt. Dies lässt sich beispielsweise mit Hilfe von chromatographischen Verfahren verfolgen und überprüfen. So lässt sich beispielsweise Komponente i) nach der Aktivierung nicht mehr durch Dünnschicht- oder Säulenchromatographie aus dem aktivierten Härtergemisch abtrennen. Die Aktivierung wird daher unter solchen Bedingungen durchgeführt, so dass praktisch eine vollständige Umsetzung der Komponente i) des Ausgangsgemischs erfolgt.

Die Lösung oder Dispersion der Komponenten i) und ii) kann gegebenenfalls noch einen Sensibilisator für die Verbindung der Formel I enthalten. Beispiele für geeignete Sensibilisatoren sind polycyclische Kohlenwasserstoffe, Aceto- oder Benzophenone, Phthalimidthioether und Thioxanthone. Weitere Beispiele für geeignete Sensibilisatoren findet man in der EP-A-152,377. Der Anteil an Sensibilisator beträgt üblicherweise 0-10 Gew.%, bezogen auf die Menge an Komponente i).

Zur Aktivierung durch aktinische Strahlung wird die Lösung oder die Dispersion enthaltend Komponenten i) und ii) in der Regel in dem Wellenlängenbereich bestrahlt, in dem der Komplex der Formel I und/oder ein gegebenenfalls anwesender Sensibilisator absorbiert. Dies wird in Abhängigkeit vom Liganden $R^1$ oder vom Sensibilisator im Bereich von etwa 200-600 nm des elektromagnetischen Spektrums liegen. Zur Bestrahlung können an sich übliche Lichtquellen verwendet werden, wie Xenon- oder Argonlampen, Wolframlampen oder insbesondere Quecksilberlampen.

Die Bestrahlungsdauer ist im wesentlichen abhängig von den Verfahrensparametern, wie Intensität, Wellenlänge und Bestrahlungstemperatur. Die optimale Gestaltung der Aktivierung kann vom Fachmann anhand von Routineversuchen ermittelt werden.

Die Aktivierung mittels Bestrahlung kann durch Erhitzen verkürzt werden. Gängige Temperaturen liegen im Bereich von 30-180°C.

Ferner kann die Aktivierung allein durch Erhitzen erfolgen. Dazu erhitzt man die Lösung oder Dispersion aus Komponenten i) und ii) soweit, dass eine Umsetzung des Komplexes der Formel I erfolgt. Auch in diesem Falle werden Höhe der Temperatur und Dauer der Aktivierung im wesentlichen von der Art des Komplexes der Formel I bestimmt. Zum Erzielen schneller Umsetzungszeiten wird man die Lösung bis etwa zum Zersetzungspunkt des Komplexes der Formel I erhitzen.

Zur Herstellung des Ausgangsgemisches kann praktisch jedes Mengenverhältnis gewählt werden, wobei Komponente i) in der Regel im Unterschuss vorliegt. Die Auswahl der Mengenverhältnisse der Komponenten erfolgt nach der gewünschten Geschwindigkeit der Härtungsreaktion. Diese ist im allgemeinen umso grösser, je höher der Anteil an Komponente i) im Ausgangsgemisch ist. Die Gewichtsverhältnisse von Komponente i) und Komponente ii) im Ausgangsgemisch betragen in der Regel 0,2:100 bis 1:1, vorzugsweise 0,5:100 bis 5:100.

In einer bevorzugten Ausführungsform betrifft die Erfindung eine Stoffzusammensetzung erhältlich durch

A) Lösen der Komponente i) in einer Kombination der Komponente ii) mit einer weiteren Komponente iii), und

B) Aktivieren dieser Lösung in der oben definierten Weise, wobei Komponente i) die oben definierte Bedeutung besitzt, Komponente ii) ein Anhydrid einer Polycarbonsäure, insbesondere ein Anhydrid einer Dicarbonsäure, ist und Komponente iii) eine Polycarbonsäure oder ein carboxylterminiertes Addukt einer Polycarbonsäure oder eines ihrer esterbildenden Derivate an einen mindestens zweiwertigen Alkohol und/oder an ein mindestens zweiwertiges Phenol ist.

In diesem Fall betragen die Gewichtsverhältnisse der Komponenten i):ii) + iii) in der Ausgangslösung in der Regel 0,2:100 bis 1:1, vorzugsweise 0,5:100 bis 5:100, und das Gewichtsverhältnis von Komponente ii) zu iii) beträgt vorzugsweise 100:1 bis 100:20.

Aktivierte Härterkombinationen aus Komponenten i), ii) und iii) zeichnen sich im allgemeinen durch eine besonders hohe Aktivität aus.

Als Polycarbonsäuren iii) oder als Bildungskomponenten der carboxyl-terminierten Addukte iii) können ganz allgemein aliphatische, cycloaliphatische, aromatische oder araliphatische Verbindungen mit wenigstens zwei Carboxylgruppen, insbesondere mit zwei Carboxylgruppen, verwendet werden.

Beispiele für solche Polycarbonsäuren sind bereits weiter oben aufgezählt. Diese Polycarbonsäuren können als solche verwendet werden oder sie werden zur Verkappung der jeweiligen Alkoholkomponente eingesetzt. Neben den Carbonsäuren lassen sich bei der Verkappung auch deren esterbildenden Derivate, wie Anhydride, Säurechloride oder Ester einsetzen.

Zu den möglichen Alkoholkomponenten zählen aliphatische Diole, wie Alkylendiole, beispielsweise Ethylenglykol, Propan-1,2-diol, Propan1,3-diol, Butan-1,4-diol, Pentan-1,5-diol, Neopentylglykol (2,2-Dimethylpropandiol),Hexan-1,6-diol, Octan-1,8-diol, Decan-1,10-diol oder Dodecan-1,12-diol; oder höherwertige Alkohole, wie 1,1,1-Trimethylolethan, 1,1,1-Trimethylolpropan, Glycerin oder Pentaerithtrit; oder cycloaliphatische Diole, wie 1,3- oder 1,4-Dihydroxycyclohexan, 1,4-Cyclohexandimethanol, Bis-(4-hydroxycyclohexyl)-methan oder 2,2-Bis-(4-hydroxycyclohexyl)-propan; oder Bisphenole, wie Resorcin, Hydrochinon, Bis-(4-hydroxyphenyl)-methan, Bis-(4-hydroxyphenyl)-ether oder 2,2-Bis-(4-hydroxyphenyl)-propan.

Neben solchen niedermolekularen Alkoholen oder Phenolen können durchaus auch hydroxylterminierte Präpolymere verwendet werden. Solche Verbindungen sind dem Fachmann an sich bekannt. Beispiele dafür sind hydroxylterminierte Polyester, wie Polycaprolacton, und insbesondere Polyether, wie Polyalkylenetherpolyole, die durch ionische Polymerisation, Copolymerisation oder Blockcopolymerisation von Alkylenoxiden, wie Ethylenoxid, Propylenoxid oder Butylenoxid, gegebenenfalls in Gegenwart von di- oder polyfunktionellen Alkoholen, erhalten werden können.

Zur Verkappung der Alkoholkomponenten setzt man die Polycarbonsäure oder deren esterbildende Derivate im Ueberschuss ein, so dass alle Alkoholgruppen verkappt werden. Dabei können durchaus auch unreagierte saure Komponenten zurückbleiben. Die Herstellung solcher carboxyl-terminierter Komponenten ist dem Fachmann an sich bekannt und kann beispielsweise durch Schmelzkondensation oder durch Kondensation in Lösung durch Erhitzen der Bildungskomponenten durchgeführt werden.

Bevorzugt verwendet man zur Herstellung der erfindungsgemässen aktivierten Stoffzusammensetzungen als Komponente i) Verbindungen der Formel I, worin a und n 1 sind, $R^1$ ein unsubstituierter oder ein- oder zweifach mit $C_1$-$C_4$ Alkyl oder $C_1$-$C_4$ Alkoxy substituierter Benzol- oder Naphthalinrest oder ein Stilbenrest ist, $R^2$ ein unsubstituiertes Cyclopentadienylanion bedeutet und $X^-$ ein Anion ist, das ausgewählt wird aus der Gruppe bestehend aus $PF_6^-$, $AsF_6^-$, $SbF_6^-$, $BiF_6^-$, sowie aus Anionen von perfluoraliphatischen oder perfluoraromatischen Sulfonsäuren, insbesondere $CF_3$-$SO_3^-$, $C_2F_5$-$SO_3^-$, $C_3F_7$-$SO_3^-$, $C_4F_9$-$SO_3^-$, $C_6F_{13}$-$SO_3^-$, $C_8F_{17}$-$SO_3^-$, $C_6F_5$-$SO_3^-$ und $CF_3C_6F_4$-$SO_3^-$.

Die erfindungsgemässen aktivierten Härterkombinationen lassen sich mit kationisch polymerisierbaren organischen Materialien zu härtbaren Zusammensetzungen mit den oben beschriebenen vorteilhaften Eigenschaften kombinieren.

Die Erfindung betrifft daher auch härtbare Zusammensetzungen enthaltend

    a) ein kationisch polymerisierbares organisches Material, und

    b) eine aktivierte Härterkombination, wie oben definiert.

Die Menge an Härterkomponente b) beträgt in der Regel 0,05-0,5 Gewichtsteile, vorzugsweise 0,15-0,3 Gewichtsteile, bezogen auf einen Gewichtsteil des polymerisierbaren Materials.

Das Vermischen der Komponenten a) und b) erfolgt in der Regel bei niedrigen Temperaturen, beispielsweise unterhalb von 50°C, um ein vorzeitiges Gelieren oder Aushärten zu vermeiden.

Beispiele für kationisch polymerisierbare organische Materialien sind in den oben erwähnten Publikationen beschrieben, welche die Polymerisation solcher härtbarer Materialien in Gegenwart von Metallocensalzen betreffen.

Bevorzugt sind härtbaren Zusammensetzungen, worin Komponente a) ein kationisch polymerisierbarer cyclischer Ether ist.

Zu den besonders bevorzugten Komponenten a) zählen die Epoxidharze.

Die Erfindung betrifft daher insbesondere härtbare Zusammensetzungen enthaltend als Komponente a) eine Verbindung mit durchschnittlich mindestens zwei 1,2-Epoxidgruppen pro Molekül und Komponente b), wie oben definiert.

Es lassen sich eine Vielzahl von gängigen Epoxidharzen als Komponente a) einsetzen. Die Verbindungen können allein oder als Gemisch mehrerer Epoxidharze oder auch in Kombination mit anderen durch Komponente b) härtbaren Monomeren eingesetzt werden.

Beispiele für Epoxidharze sind:

I) Polyglycidyl- und Poly-($\beta$-methylglycidyl)-ester, die beispielsweise durch Umsetzung von einer Verbindung enthaltend mindestens zwei Carboxylgruppen im Molekül mit Epichlorhydrin, Glycerindichlorhydrin oder mit $\beta$-Methylepichlorhydrin in Gegenwart von Basen erhalten werden können.

Beispiele für Verbindungen mit mindestens zwei Carboxylgruppen im Molekül sind die Polycarbonsäuren, wie bereits weiter oben für Komponente ii) beschrieben.

II) Polyglycidyl- und Poly-($\beta$-methylglycidyl)-ether, die beispielsweise durch Umsetzung einer Verbindung enthaltend mindestens zwei alkoholische Hydroxylgruppen und/oder phenolische Hydroxylgruppen im Molekül mit Epichlorhydrin, Glycerindichlorhydrin oder mit $\beta$-Methylepichlorhydrin unter alkalischen Bedingungen oder in Anwesenheit eines sauren Katalysators und anschliessender Alkalibehandlung erhalten werden können.

Beispiele für Verbindungen mit mindestens zwei alkoholischen Hydroxylgruppen und/oder phenolischen Hydroxylgruppen im Molekül sind aliphatische Alkohole, wie Ethylenglykol, Diethylenglykol und höhere Poly-(oxyethylen)-glykole, Propan-1,2-diol, Propan-1,3-diol oder höhere Poly-(oxypropylen)-glykole,Butan-1,4-diol oder höhere Poly-(oxybutylen)-glykole, Pentan-1,5-diol, Hexan-1,6-diol, Octan-1,8-diol, Decan-1,10-diol oder Dodecan-1,12-diol, Hexan-2,4,6-triol, Glycerin, 1,1,1-Trimethylolpropan, Pentaerithrit, Sorbit oder Polyepichlorhydrine; oder cycloaliphatische Alkohole, wie 1,3- oder 1,4-Dihydroxycyclohexan, 1,4-Cyclohexandimethanol, Bis-(4-hydroxycyclohexyl)-methan, 2,2-Bis-(4-hydroxycyclohexyl)-propan oder 1,1-Bis-(hydroxymethyl)-cyclohex-3-en; oder Alkohole enthaltend aromatische Gruppen, wie N,N-Bis-(2-hydroxyethyl)-anilin oder p,p'-Bis-(2-hydroxyethylamino)-diphenylmethan; oder ein- oder mehrkernige Polyphenole, wie Resorcin, Hydrochinon, Bis-(4-hydroxyphenyl)-methan, 2,2,-Bis-(4-hydroxyphenyl)-propan, bromiertes 2,2,-Bis-(4-hydroxyphenyl)-propan, Bis-(4-hydroxyphenyl)-ether, Bis-(4-hydroxyphenyl)-sulfon, 1,1,2,2-Tetrakis-(4-hydroxyphenyl)-ethan oder Novolake, die durch Kondensation von Aldehyden, wie Formaldehyd, Acetaldehyd, Chloral oder Furfuraldehyd mit gegebenenfalls alkyl- oder halogensubstituierten Phenolen, wie Phenol, den oben beschriebenen Bisphenolen, 2-oder 4-Methylphenol, 4-tert.Butylphenol, p-Nonylphenol oder 4-Chlorphenol erhältlich sind.

III) Poly-(S-glycidyl)-verbindungen, wie beispielsweise Di-S-glycidylderivate, die sich von Dithiolen, wie Ethan-1,2-dithiol oder von Bis-(4-mercaptomethylphenyl)-ether, ableiten.

IV) Epoxidierungsprodukte von Dienen oder Polyenen, wie cycloaliphatische Epoxidharze, die beispielsweise durch Epoxidierung ethylenisch ungesättigter cycloaliphatischer Verbindungen hergestellt werden können. Beispiele dafür sind 1,2-Bis-(2,3-epoxicyclopentyloxy)-ethan, 2,3-Epoxycyclopentylglycidylether, Bis-(2,3-epoxycyclopentyl)-ether, 5(6)-Glycidyl-2-(1,2-epoxyethyl)-bicyclo[2.2.1]heptan, Dicyclopentadiendioxid, 3,4-Epoxy-6-methylcyclohexylmethyl-3',4'-epoxy-6'-methylcyclohexancarboxylat oder 3,4-Epoxycyclohexylmethyl-3',4'-epoxycyclohexancarboxylat.

Es lassen sich aber auch Epoxidharze verwenden, bei denen die 1,2-Epoxidgruppen an unterschiedliche Heteroatome bzw. funktionelle Gruppen gebunden sind; zu solchen Verbindungen zählen beispielsweise der Glycidylether-glycidylester der Salicylsäure.

Ganz besonders bevorzugt sind härtbare Gemische enthaltend

a) ein cycloaliphatisches Epoxidharz, insbesondere eines mit zwei 1,2-Epoxidgruppen, und
b) eine aktivierte Härterkombination, wie oben definiert, die sich ableitet von einer Verbindung der Formel I und einem Polyisocyanat.

Gemische dieses Typs zeichnen sich durch eine besonders hohe Lagerstabilität bei Raumtemperatur auf.

Die erfindungsgemässen härtbaren Zusammensetzungen lassen sich in beliebiger Form erhalten, beispielsweise als homogene flüssige oder feste Gemische. Diese Zusammensetzungen sind in Abweichung von härtbaren Zusammensetzungen enthaltend Eisen-Aren Initiatoren im allgemeinen nicht mehr strahlungsempfindlich. Sie lassen sich direkt thermisch härten, wobei die Härtungstemperaturen im allgemeinen wesentlich unter denen vorbekannter Zusammensetzungen liegen.

Das Einmischen der vorzugsweise flüssigen aktivierten Härterkomponente in das kationisch polymerisierbare Material kann mit üblichen Mitteln, wie mit Rührern, Walzen oder Knetern, durchgeführt werden und erfolgt vorzugsweise bei Temperaturen unterhalb von 50°C.

Vorzugsweise härtet man unterhalb von 200°C, insbesondere im Bereich von 50 bis 180°C. Es lässt sich allerdings auch eine Vorhärtung bei tieferen Temperaturen bis zum Gelieren der härtbaren Zusammensetzung durchführen, an die sich dann eine Aushärtung bei höheren Temperaturen anschliesst.

Die gehärteten Produkte zeichnen sich durch gute mechanische und elektrische Endeigenschaften aus, insbesondere ist die geringe Versprödung der Endprodukte als überraschend anzusehen. Ferner lassen sich bei der Härtung hohe Durchsätze erzielen, insbesondere bei maschineller Verarbeitung, da eine rasche Gelierung bei tiefen Temperaturen möglich ist und da auch die Nachhärtzeiten bei höherer Temperatur kurz gehalten werden können. Als weiterer Vorteil bei der Verarbeitung der erfindungsgemässen härtbaren Zusammensetzungen ist anzusehen, dass das Mischungsverhältnis der Komponenten a) zu b) im allgemeinen nicht kritisch für die Härtungsbedingungen ist. So kann dieses Mischungsverhältnis insbesondere bei der maschinellen Verarbeitung variiert werden, ohne dass dadurch jedes Mal die Härtungsbedingungen angepasst werden müssen.

Die Erfindung betrifft daher auch ein Verfahren zur Herstellung von gehärteten Produkten, dadurch gekennzeichnet, dass man eine erfindungsgemässe härtbare Zusammensetzung durch Erhitzen härtet; ferner betrifft die Erfindung die durch Erhitzen der erfindungsgemässen härtbaren Zusammensetzung erhältlichen gehärteten Produkte.

Gewünschtenfalls kann man den härtbaren Zusammensetzungen zur Herabsetzung der Viskosität reaktive Verdünner, wie z.B. Styroloxid, Butylglycidylether, 2,2,4-Trimethylpentylglycidylether, Phenylglycidylether, Kresylglycidylether oder Glycidylester von synthetischen, hochverzweigten, in der Hauptsache tertiären aliphatischen Monocarbonsäuren, zusetzen.

Als weitere übliche Zusätze können die erfindungsgemässen Zusammensetzungen ferner Weichmacher, Streck-, Füll- und Verstärkungsmittel, wie beispielsweise Steinkohlenteer, Bitumen, Textilfasern, Glasfasern, Asbestfasern, Borfasern, Kohlenstoff-Fasern, mineralische Silikate, Glimmer, Quarzmehl, Aluminiumoxidhydrat, Bentonite, Wollastonit, Kaolin, Kieselsäureaerogel oder Metallpulver, z.B. Aluminiumpulver oder Eisenpulver, ferner Pigmente und Farbstoffe, wie Russ, Oxidfarben und Titandioxid, sowie Flammschutzmittel, Entschäumungsmittel, Thixotropiemittel, Verlaufmittel (die zum Teil auch als Formtrennmittel Anwendung finden), wie Silicone, Wachse und Stearate, oder Haftvermittler, Antioxidantien und Lichtschutzmittel enthalten.

Der Anteil von Zusätzen beläuft sich üblicherweise auf 0-85 Gewichtsteile, bezogen auf 100 Gewichtsteile der härtbaren Zusammensetzung.

Die erfindungsgemässen härtbaren Zusammensetzungen lassen sich ganz allgemein zur Herstellung von gehärteten Produkten einsetzen, und können in der dem jeweils speziellen Anwendungsgebiet angepassten Formulierung, beispielsweise als Beschichtungsmassen, Lacke, Pressmassen, Tauchharze, Giessharze, Imprägnierharze, Laminierharze, Klebmittel oder Matrixharze eingesetzt werden.

Insbesondere lassen sich die erfindungsgemässen härtbaren Zusammensetzungen als Enkapsulier- oder Umhüllungsmaterial für elektronische Bauteile, zur Herstellung von isolierenden tragenden Bauteilen oder als Einkomponentenklebstoff einsetzen.

Die Erfindung betrifft auch die Verwendung der härtbaren Gemische für die oben erwähnten Zwecke.

Die folgenden Beispiele erläutern die Erfindung:

## I. Herstellung der Härterkomponenten

### I.1. Härterkomponente A

Eine Lösung bestehend aus 162 g Methyltetrahydrophthalsäureanhydrid (Hitachi HN 2200), 38 g eines Umsetzungsproduktes aus 2 Aequivalenten Tetrahydrophthalsäureanhydrid und 1 Aequivalent 2,2-Dimethylpropandiol und 1 g ($\eta^6$-Cumol)($\eta^5$-cyclopentadienyl)-eisen-II-hexafluoroantimonat werden in einem 250 ml Photoreaktor durch ein Tauchrohr aus Pyrex mit einer 125 W Quecksilberhochdrucklampe unter Argonatmosphäre und Rühren während 1,5 Stunden bei Raumtemperatur bestrahlt. Dabei resultiert eine dunkelbraune, klare Lösung.

### I.2. Härterkomponente B

Eine Lösung bestehend aus 162 g Methyltetrahydrophthalsäureanhydrid (Hitachi HN 2200), 38 g eines Umsetzungsproduktes aus 2 Aequivalenten Tetrahydrophthalsäureanhydrid und 1 Aequivalent 2,2-Dimethylpropandiol und 1 g ($\eta^6$-1-Methylnaphthalin)($\eta^5$-cyclopentadienyl)-eisen-II-hexafluoroantimonat werden in einem 500 ml Rundkolben unter Argonatmosphäre während 1 Stunde auf 140°C erwärmt. Nach Abkühlen auf Raumtemperatur resultiert eine dunkelbraune, klare Lösung.

### I.3. Härterkomponente C

Eine Lösung bestehend aus 100 g Methylhexahydrophthalsäureanhydrid und 1 g ($\eta^6$-Cumol)($\eta^5$-cyclopentadienyl)-eisen-II-hexafluoroantimonat werden in einem 250 ml Photoreaktor durch ein Tauchrohr aus Pyrex mit einer 125 W Quecksilberhochdrucklampe unter Argonatmosphäre und Rühren während 1,5 Stunden bei Raumtemperatur bestrahlt. Dabei resultiert eine dunkelbraune, klare Lösung.

### I.4. Härterkomponente D

60,4 g Bis-($\eta^6$-mesitylen)-eisen-II-hexafluoroantimonat werden fein pulverisiert und in 205 g Methylhexahydrophthalsäureanhydrid dispergiert. Die Dispersion wird mit Argon entgast, inertisiert und unter Rühren auf 120°C erwärmt. Nach 45 Minuten hat sich eine klare dunkelbraune Lösung gebildet, welche während 15 Minuten am Vakuum (0,1 mbar) bei 120°C von flüchtigen Bestandteilen befreit wird. Es resultieren 246,1 g einer viskosen braunen Flüssigkeit. Ein Teil dieses Produkts wird in 30 Teilen Methylhexahydrophthalsäureanhydrid gelöst und ergibt die Härterkomponente D.

### I.5. Härtekomponente E

Eine Lösung bestehend aus 100 g Isophorondiisocyanat (IPDI) und 5 g ($\eta^6$-Cumol)($\eta^5$-cyclopentadienyl)-eisen-II-hexa-fluoroantimonat wird in einem 250 ml Photoreaktor durch ein Tauchrohr aus Pyrex mit einer 125 W Quecksilberhochdrucklampe unter Argonatmosphäre und Rühren während 1,5 Stunden bei Raumtemperatur bestrahlt. Dabei resultiert eine hellbraune klare Lösung.

## II. Anwendungsbeispiele

### II.1. Beispiel A

100 g eines technischen Bisphenol-A-diglycidylethers (Epoxidwert: 5,2 Aequ./kg) und 25 g der Härterkomponente A aus Beispiel I.1. werden in einer Aluminiumform bei Raumtemperatur vermischt und anschliessend zwei Stunden auf 180°C erwärmt. Es resultiert ein dunkelbrauner Formkörper, der eine Glasumwandlungstemperatur von 131°C (gemessen im DSC-Experiment) besitzt.

### II.2. Beispiel B

70 g eines technischen Bisphenol-A-diglycidylethers (Epoxidwert: 5,2 Aequ./kg), 30 g 3,4-Epoxicyclohexylmethyl-3',4'-epoxicyclohexancarboxylatund 25 g der Härterkomponente B aus Beispiel I.2. werden in einer Aluminiumform bei Raumtemperatur vermischt und anschliessend zwei Stunden auf 180°C erwärmt. Es resultiert ein dunkelbrauner Formkörper, der eine Glasumwandlungstemperatur von 149°C (gemessen im DSC-Experiment) besitzt.

### II.3. Beispiel C

70 g eines technischen Bisphenol-A-diglycidylethers (Epoxidwert: 5,2 Aequ./kg), 30 g 3,4-Epoxicyclohexylmethyl-3',4-epoxicyclohexancarboxylat, 25 g der Härterkomponente A aus Beispiel I.1. und 200 g Quarzmehl (Novacite 1250) werden in einer Aluminiumform bei Raumtemperatur vermischt und anschliessend zwei Stunden auf 180°C erwärmt. Es resultiert ein dunkelbrauner Formkörper, der eine Glasumwandlungstemperatur von 154°C (gemessen im DSC-Experiment) und einen linearen thermischen Ausdehnungskoeffizienten von 40 x $10^{-6}$ [$°C^{-1}$] bei 80°C besitzt.

## II.4. Beispiel D

70 g eines technischen Bisphenol-A-diglycidylethers (Epoxidwert: 5,2 Aequ./kg), 30 g 3,4-Epoxicyclohexylmethyl-3',4'-epoxicyclohexancarboxylat und 25 g der Härterkomponente C aus Beispiel I.3. werden in einer Aluminiumform bei Raumtemperatur vermischt und anschliessend zwei Stunden auf 180°C erwärmt. Es resultiert ein dunkelbrauner Formkörper, der eine Glasumwandlungstemperatur von 185°C (gemessen im DSC-Experiment) besitzt.

## II.5. Beispiel E

100 g eines Bisphenol A-diglycidylethers (Epoxidwert 5,2 Aequ/kg) und 25 g der Härterkomponente D aus Beispiel I.4. werden in einer Aluminiumform bei Raumtemperatur vermischt und anschliessend 2 Std. auf 130°C und 4 Std. auf 180°C erwärmt. Es resultiert ein dunkler Formkörper, der eine Glasumwandlungstemperatur von 159°C erreicht (gemessen mit DSC).

## II.6. Beispiel F

100 g 3,4-Epoxicyclohexylmethyl-3',4'-epoxycyclohexancarboxylat und 25 g der Härtekomponente E aus Beispiel I.5. werden in einer Aluminiumform bei Raumtemperatur vermischt und anschliessend 0,5 Stunden bei 130°C und 4 Stunden bei 180°C erwähnt. Es resultiert ein dunkelbrauner Formkörper, der eine Glasumwandlungstemperatur von 147°C (gemessen im DSC-Experiment) besitzt.

## Patentansprüche

1. Härterzusammensetzung für kationisch polymerisierbares Material, die erhältlich ist durch A) Lösen oder Dispergieren einer Komponente i) in einer Komponente ii), wobei Komponente i) eine Verbindung der Formel I ist

$$[(R^1)(R^2Fe^{II})_a]^{+na} \, na \, X^- \qquad (I)$$

und Komponente ii) ausgewählt wird aus der Gruppe bestehend aus einer Polycarbonsäure, einem Anhydrid auf Basis einer Polycarbonsäure oder einem Polyisocyanat, worin $R^1$ in Formel I ein $\pi$-Aren ist, $R^2$ ein $\pi$-Aren oder ein Anion eines $\pi$-Arens ist, a und n unabhängig voneinander 1 oder 2 bedeuten, und X ein Anion $[LQ_m]^-$ ist oder ein Anion einer gegebenenfalls teil- oder perfluorierten aliphatischen, cycloaliphatischen, aromatischen oder araliphatischen Carbonsäure oder Sulfonsäure ist, wobei L ausgewählt ist aus der Gruppe bestehend aus B, P, As, Sb und Bi, Q ein Halogenatom darstellt und m der um Eins vergrösserten Wertigkeit von L entspricht, und B) Aktivieren besagter Lösung oder Dispersion enthaltend Komponenten i) und ii) durch Bestrahlung mit aktinischer Strahlung oder durch Erhitzen, so dass eine so vollständige Umsetzung der Komponente i) des Ausgangsgemisches erfolgt, dass sich diese nicht mehr durch Dünnschicht- oder Säulenchromatographie aus der aktivierten Härterzusammensetzung abtrennen lässt.

2. Stoffzusammensetzung gemäss Anspruch 1, worin $R^1$ oder $R^2$ carbocyclisch-aromatische Kohlenwasserstoffe mit 6-24 C-Atomen im aromatischen Ring, oder heterocyclisch-aromatische Kohlenwasserstoffe mit 4-11 C-Atomen und 1 oder 2 O- oder S-Atomen im aromatischen Ring bedeuten.

3. Stoffzusammensetzung gemäss Anspruch 1, worin $R^2$ ein Cyclopentadienylanion bedeutet.

4. Stoffzusammensetzung gemäss Anspruch 1, worin $X^-$ $PF_6^-$, $AsF_6^-$, $SbF_6^-$, $BiF_6^-$ oder ein Anion von perfluoraliphatischen oder perfluoraromatischen Sulfonsäuren ist.

5. Stoffzusammensetzung gemäss Anspruch 1, worin Komponente ii) ein Polyisocyanat ist.

6. Stoffzusammensetzung gemäss Anspruch 1, worin Komponente ii) ein Anhydrid einer Polycarbonsäure oder ein Gemisch solcher Anhydride ist, das bei Temperaturen unterhalb von 50°C flüssig ist.

7. Stoffzusammensetzung gemäss Anspruch 1, worin Komponenten i) und ii) und deren Mengen so ausgewählt sind, so dass sich eine Lösung aus diesen Komponenten herstellen lässt.

8. Stoffzusammensetzung gemäss Anspruch 1, erhältlich durch
A) Lösen der Komponente i) in einer Kombination der Komponente ii) mit einer weiteren Komponente iii), und
B) Aktivieren dieser Lösung gemäss Anspruch 1, wobei Komponente i) die in Anspruch 1 definierte Bedeutung besitzt, Komponente ii) ein Anhydrid einer Polycarbonsäure ist und Komponente iii) eine Polycarbonsäure oder ein carboxyl-terminiertes Addukt einer Polycarbonsäure oder eines ihrer esterbildenden Derivate an einen mindestens zweiwertigen Alkohol und/oder an ein mindestens zweiwertiges Phenol ist.

9. Stoffzusammensetzung gemäss den Ansprüchen 1 oder 8, worin die Gewichtsverhältnisse von Komponente i) und Komponente ii) oder von Komponente i) und Komponenten ii) + iii) im Ausgangsgemisch 0,5:100 bis 5:100 betragen.

10. Stoffzusammensetzung gemäss Anspruch 1, worin als Komponente i) Verbindungen der Formel I verwendet werden, worin a und n 1 sind, $R^1$ ein unsubstituierter oder ein- oder zweifach mit $C_1$-$C_4$ Alkyl oder $C_1$-$C_4$ Alkoxy substituierter Benzol- oder Naphthalinrest oder ein Stilbenrest ist, $R^2$ ein unsubstituiertes Cyclopentadienylanion bedeutet und $X^-$ ein Anion ist, das ausgewählt wird aus der Gruppe bestehend aus $PF_6^-$, $AsF_6^-$, $SbF_6^-$, $BiF_6^-$ sowie aus Anionen von perfluoraliphatischen oder perfluoraromatischen Sulfonsäuren, insbesondere $CF_3$-$SO_3^-$, $C_2F_5$-$SO_3^-$, $C_3F_7$-$SO_3^-$, $C_4F_9$-$SO_3^-$, $C_6F_{13}$-$SO_3^-$, $C_8F_{17}$-$SO_3^-$, $C_6F_5$-$SO_3^-$ und $CF_3$-$C_6F_4$-$SO_3^-$.

11. Härtbare Zusammensetzung enthaltend
a) ein kationisch polymerisierbares organisches Material, und
b) eine aktivierte Härterkombination gemäss den Ansprüchen 1 bis 10.

12. Härtbare Zusammensetzung gemäss Anspruch 11, worin Komponente a) eine Verbindung mit durchschnittlich mindestens zwei 1,2-Epoxidgruppen pro Molekül ist.

13. Härtbare Zusammensetzung gemäss Anspruch 11, worin Komponente a) ein cycloaliphatisches Epoxidharz ist und Komponente b) eine aktivierte Härterkombination gemäss Anspruch 1 bedeutet, worin Komponente ii) ein Polyisocyanat ist.

14. Verfahren zur Herstellung gehärteter Produkte durch Erhitzen einer härtbaren Zusammensetzung, dadurch gekennzeichnet, dass man eine härtbare Zusammensetzung gemäss den Ansprüchen 11 bis 13 verwendet.

15. Verwendung der härtbaren Zusammensetzung gemäss den Ansprüchen 11 - 13 als Enkapsulier- oder Umhüllungsmaterial für elektronische Bauteile, zur Herstellung von isolierenden tragenden Bauteilen oder als Klebstoff.

**Claims**

1. A curing composition for cationically polymerizable material, which is obtainable by
A) dissolving or dispersing a component i) in a component ii), component i) being a compoud of the formula I

$$[(R^1)(R^2Fe^{II})_a]^{+na}\ na\ X^- \qquad (I),$$

and component ii) being selected from the group consisting of a polycarboxylic acid, an anhydride based on a polycarboxylic acid, or a polyisocyanate, in which, in formula I, $R^1$ is a $\pi$-arene, $R^2$ is a $\pi$-arene or an anion of a $\pi$-arene, a and n, independently of one another, are 1 or 2, and X is an anion $[LQ_m]^-$ or an anion of an unfluorinated, partially fluorinated or perfluorinated aliphatic, cycloaliphatic, aromatic or araliphatic carboxylic acid or sulfonic acid, in which L is selected from the group consisting of B, P, As, Sb and Bi, Q is a halogen atom and m corresponds to the valency of L increased by one, and
B) activating said solution or dispersion containing components i) and ii) by irradiation with actinic radiation or by heating, so that the conversion of component i) of the starting mixture is so complete that it can no longer be separated off from the activated curing composition by thin-layer or column chromatography.

2. A composition of matter according to claim 1, in which $R^1$ or $R^2$ are carbocyclic-aromatic hydrocarbons having 6-24 C atoms in the aromatic ring, or heterocyclic-aromatic hydrocarbons having 4-11 C atoms and 1 or 2 O atoms or S atoms in the aromatic ring.

3. A composition of matter according to claim 1, in which $R^2$ is a cyclopentadienyl anion.

4. A composition of matter according to claim 1, in which $X^-$ is $PF_6^-$, $AsF_6^-$, $SbF_6^-$, $BiF_6^-$ or an anion of perfluoroaliphatic or perfluoroaromatic sulfonic acids.

5. A composition of matter according to claim 1, in which component ii) is a polyisocyanate.

6. A composition of matter according to claim 1, in which component ii) is an anhydride of a polycarboxylic acid or a mixture of this type of anhydride, which is liquid at temperatures below 50 °C.

7. A composition of matter according to claim 1, in which components i) and ii) and their amounts are chosen such that a solution can be prepared from these components.

8. A composition of matter according to claim 1, obtainable by

A) dissolving component i) in a combination of component ii) with a further component iii) and

B) activating this solution according to claim 1, in which component i) is as defined in claim 1, component ii) is an anhydride of a polycarboxylic acid and component iii) is a polycarboxylic acid or a carboxyl-terminated adduct of a polycarboxylic acid or of one of its ester-forming derivatives to an at least dihydric alcohol and/or to an at least dihydric phenol.

9. A composition of matter according to either of claims 1 and 8, in which the weight ratio of component i) and component ii) or of component i) and components ii) + iii) in the starting mixture is 0.5:100 to 5:100.

10. A composition of matter according to claim 1, in which the compounds used as component i) are those of the formula I in which a and n are 1, $R^1$ is a benzene or naphthalene radical which is unsubstituted or mono- or disubstituted by $C_1$-$C_4$alkyl or $C_1$-$C_4$alkoxy or is a stilbene radical, $R^2$ is an unsubstituted cyclopentadienyl anion and $X^-$ is an anion selected from the group consisting of $PF_6^-$, $AsF_6^-$, $SbF_6^-$, $BiF_6^-$ and of anions of perfluoroaliphatic or perfluoroaromatic sulfonic acids, in particular $CF_3$-$SO_3^-$, $C_2F_5$-$SO_3^-$, $C_3F_7$-$SO_3^-$, $C_4F_9$-$SO_3^-$, $C_6F_{13}$-$SO_3^-$, $C_8F_{17}$-$SO_3^-$, $C_6F_5$-$SO_3^-$ and $CF_3$-$C_6F_4$-$SO_3^-$.

11. A curable composition comprising

a) a cationically polymerizable organic material and

b) an activated curing combination according to claims 1 to 10.

12. A curable composition according to claim 11, in which component a) is a compound having on average at least two 1,2-epoxy groups per molecule.

13. A curable composition according to claim 11, in which component a) is a cycloaliphatic epoxy resin and component b) is an activated curing combination according to claim 1, in which component ii) is a polyisocyanate.

14. A process for the preparation of cured products by heating a curable composition, which comprises using a curable composition according to claims 11 to 13.

15. Use of the curable composition according to claims 11 - 13 as encapsulating or sheathing material for electronic components, for the manufacture of insulating structural supports or as adhesive.

**Revendications**

1. Composition durcissante pour un matériau polymérisable par voie cationique, cette composition pouvant être obtenue par :

A) Dissolution ou dispersion d'un composant (i) dans un composant (ii), le composant (i) étant un composé de formule I :

$$[(R^1)(R^2Fe^{II})_a]^{+na} \, na \, X^- \qquad (I),$$

et le composant (ii) étant choisi dans l'ensemble consistant en un acide polycarboxylique, un anhydride à base d'un acide polycarboxylique ou un polyisocyanate, et $R^1$ représentant dans la formule I un arène-$\pi$, $R^2$ représentant un arène-$\pi$ ou un anion d'un arène-$\pi$, a et n valant, indépendamment l'un de l'autre 1 ou 2, et X représentant un anion $[LQ_m]^-$ , ou un anion d'un acide carboxylique ou sulfonique, aliphatique, cycloaliphatique, aromatique ou araliphatique éventuellement partiellement fluoré ou perfluoré, L étant choisi dans l'ensemble consistant en B, P, As, Sb et Bi, Q représentant un halogène et m correspondant à la valeur de L augmentée d'une unité, et (B) activation de ladite solution ou dispersion contenant les composants (i) et (ii) par exposition d'irradiation par un rayonnement actinique ou par chauffage, de sorte qu'il en résulte une réaction du composant (i) du mélange de départ si complète que l'on ne peut plus séparer celui-ci, par chromatographie en couche mince ou en chromatographie sur colonne, de la composition durcissante activée.

2. Composition de matière selon la revendication 1, dans laquelle $R^1$ ou $R^2$ représentent des hydrocarbures carbocycliques aromatiques comportant 6 à 24 atomes de carbone dans le noyau aromatique ou des hydrocarbures hétérocycliques aromatiques comportant 4 à 11 atomes de carbone et 1 ou 2 atomes de O ou de S dans le noyau aromatique.

3. Composition de matière selon la revendication 1, dans laquelle $R^2$ représente un anion cyclo-

pentadiényle.

4. Composition de matière selon la revendication 1, dans laquelle $X^-$ représente $PF_6$, $AsF^6$, $SbF_6$ $BiF_4$ ou un anion d'acides sulfoniques perfluoro-aliphatiques ou perfluoro aromatiques.

5. Composition de matière selon la revendication 1, dans laquelle le composant (ii) est un polyisocyanate.

6. Composition de matière selon la revendication 1, dans laquelle le composant (ii) est un anhydride d'un acide polycarboxylique ou un mélange de tels anhydrides, qui est liquide à des températures inférieures à 50°C.

7. Composition de matière selon la revendication 1, dans laquelle les composants (i) et (ii) et leurs quantités sont choisis de façon à permettre la préparation d'une solution obtenue à partir de ces composants.

8. Composition de matière selon la revendication 1, que l'on peut obtenir par :
   A) dissolution du composant (i) dans une combinaison du composant (ii) avec un autre composant (iii) et,
   B) activation de cette solution selon la revendication 1, le composant (i) ayant la signification définie à la revendication 1, le composant (ii) étant un anhydride d'un acide polycarboxylique et le composant (iii) étant un acide polycarboxylique ou un produit d'addition, terminé par un groupe carboxyle, d'un acide polycarboxylique ou d'un dérivé formateur d'un ester d'un tel acide sur un alcool au moins divalent (un dialcool) et/ou sur un phénol au moins divalent (sur un biphénol).

9. Composition de matière selon les revendications 1 ou 8, dans laquelle les rapports pondéraux entre le composant (i) et le composant (ii) ou le composant (i) et les composants (ii) plus (iii) valent, dans le mélange de départ, 0,5:100 à 5:100.

10. Composition de matière selon la revendication 1, dans laquelle on utilise comme composant (i) des composés de formule I, dans laquelle a et n valent 1, $R^1$ représente un reste benzène ou naptalène non substitué ou substitué une ou deux fois par un groupe alkyle en $C_1$ à $C_4$ ou par un groupe alcoxy en $C_1$ à $C_4$, ou un reste stilbène; $R^2$ représente un anion cyclopentadiényle non substitué et $X^-$ représente un anion qui est choisi dans l'ensemble consistant en $PF_6$, $AsF_6$, $SbF_6$, $BF6$, ainsi que parmi des anions d'acides sulfoniques perfluoro-aliphatiques ou perfluoro-aromatiques, en particulier $CF_3-SO_3$, $C_2F_5-SO_3$, $F_7-SO_3$, $C_4F_9-SO_3$, $C_6F_{11}-SO_3$, $C_8F_{17}-SO_3$, $C_6F_5-SO_3$ et $CF_3C_6F_4-SO_3$.

11. Composition durcissable contenant :
    a) un matériau organique polymérisable par voie cationique, et
    b) une combinaison durcissante activée, selon les revendications 1 à 10.

12. Composition durcissable selon la revendication 11, dans laquelle le composant (a) est un composé comportant en moyenne deux groupes 1,2-époxydes par molécule.

13. Composition durcissable selon la revendication 11, dans laquelle le composant (a) est une résine époxyde cycloaliphatique et le composant (b) est une combinaison durcissante activée selon la revendication 1, le composant (ii) étant un polyisocyanate.

14. Procédé de préparation de produits durcis par chauffage d'une composition durcissable, procédé caractérisé en ce qu'on utilise une composition durcissable selon les revendications 11 à 13.

15. Utilisation de la composition durcissable selon les revendications 11 à 13 comme matière d'encapsulation et d'enveloppement ou d'enrobage pour des composants électroniques, pour préparer des composants porteurs ou supports isolants ou à titre de colles ou d'adhésifs.